# EUROPÄISCHE PATENTANMELDUNG

(11) **EP 0 571 861 A1**
(43) Veröffentlichungstag der Anmeldung: **01.12.1993**
(21) Anmeldenummer: 93108019.6
(22) Anmeldetag: 17.05.1993
(51) Int. Cl.: H05K 7/20, H01L 23/473

(54) **Einbausystem für auf Leiterplatten montierte, hochintegrierte, gehäuselose Bausteine**

(30) Priorität: 27.05.1992 DE 4217599
(71) Anmelder: Siemens Nixdorf Informationssysteme Aktiengesellschaft, D-33102 Paderborn (DE)
(72) Erfinder: Bachl, Johann, W-8000 München 19 (DE)
(74) Vertreter: Fuchs, Franz-Josef, Dr.-Ing.

(57) **Zusammenfassung**

Die Erfindung bezieht sich auf ein Einbausystem für auf Leiterplatten montierte, hochintegrierte, gehäuselose Bausteine. Bei Bausteinen mit einer Wärmeverlustleistung > 50 Watt und Anschlußpins > 500 ist eine konventionelle Wärmeableitung nicht mehr ausreichend. Um eine gute Kühlung bei gleichzeitig guter Montierbarkeit der Bauelemente zu erreichen, sieht die Erfindung vor, daß der Baustein (4) mit seiner Oberseite an der Unterseite einer Subkühlplatte (2) gut wärmeleitend befestigt ist und über einen Spider (7) mit den zugehörigen Lötflecken der Leiterplatte (9) kontaktiert ist. Die Subkühlplatte (2) enthält in ihrem unterseitigen Teil konzentrisch angeordnete, mit Kühlflüssigkeit gefüllte, zum Bauelement (4) hin geöffnete Kanäle (3) und ist mit ihrer Oberseite gut wärmeleitend mit Hilfe von Druckstücken (8) zwischen Bauelement (4) und Leiterplatte (9) an die Kühlplatte (1) angedrückt.

## Beschreibung

Die Erfindung betrifft ein Einbausystem für auf Leiterplatten montierte, hochintegrierte, gehäuselose Bausteine.

Bei hochintegrierten, gehäuselosen Bausteinen mit einer Pinzahl > 500 und einer Verlustleistung > 50 Watt fällt pro Flächeneinheit eine erhebliche Wärmemenge an.

Aufgabe der vorliegenden Erfindung ist es, ein Einbausystem für auf Leiterplatten montierte, hochintegrierte, gehäuselose Bausteine mit optimaler Wärmeableitung und einfacher Montierbarkeit zu schaffen.

Zur Lösung dieser Aufgabe sieht die Erfindung vor, daß der Baustein mit seiner Oberseite an der Unterseite einer Subkühlplatte gut wärmeleitend befestigt ist und über einen Spider mit den zugehörigen Lötflecken der Leiterplatte kontaktiert ist, wobei zwischen Bauelement und Leiterplatte Druckstücke angeordnet sind, daß die Subkühlplatte in ihrem unterseitigen Teil konzentrisch angeordnete, mit Kühlflüssigkeit gefüllte, nach unten offene Kanäle enthält, und mit ihrer Oberseite gut wärmeleitend an einer Kühlplatte anliegt.

Durch die in den Kühlkanälen befindliche Flüssigkeit wird eine intensive Wärmeabfuhr erzielt. Eine zusätzliche Siede-/Kondenskühlung erreicht man dadurch, daß der Siedepunkt des Kühlmittels niedrig ist.

Die Kanäle können bei waagrechtem Einbau als Bohrungen oder ringförmige Nuten ausgeführt werden. Bei senkrechtem Einbau der Leiterplatte muß gewährleistet sein, daß genügend Freiraum für die Kondensierung über der Bausteinoberkante vorhanden ist.

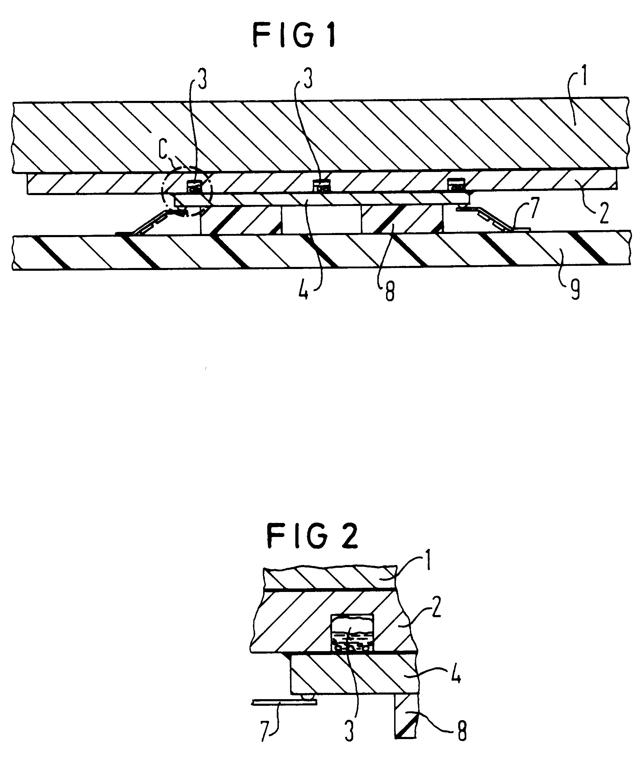

Anhand der Ausführungsbeispiele nach den Figuren 1 und 2 wird die Erfindung näher erläutert. Es zeigen
Figur 1 die komplette Ausführungsform nach der Erfindung und
Figur 2 eine Einzelheit bei C in Figur 1.

Auf den Baustein 4 ist, wie in Figur 1 gezeigt, eine Subkühlplatte 10 entweder aufgeklebt oder weich gelötet. In der Subkühlplatte befinden sich konzentrisch angeordnete Kanäle, in denen Kühlflüssigkeit fließt. Die Kanäle sind nach unten offen, so daß das Kühlmittel unmittelbar an die Oberfläche des Bauelements 4 gelangt, wodurch eine gute Wärmeabführung zu der über der Subkühlplatte 10 liegenden Kühlplatte 1 gewährleistet ist. Die Subkühlplatte 2 mit dem Bauelement 4 wird durch Druckstücke 8 zwischen der Leiterplatte 9 und der Unterseite des Bauelements 4 gut wärmeleitend mit der Kühlplatte 1 kontaktiert. Das Bauelement 4 ist über einen zweifach geknickten Spider 7 mit den jeweiligen Lötflecken auf der Leiterplatte 9 kontaktiert.

In Figur 2 ist in vergrößerter Darstellung die Einzelheit C in Figur 1 dargestellt, wobei der unmittelbare Kontakt der Kühlflüssigkeit mit der Oberfläche des Bauelements 4 deutlich zu erkennen ist. Die Kühlflüssigkeit kann, um noch eine zusätzliche Siede/Kondenskühlung zu erreichen, mit niedrigem Siedepunkt versehen sein.

## Patentansprüche

1. Einbausystem für auf Leiterplatten montierte hochintegrierte, gehäuselose Bausteine, **dadurch gekennzeichnet,** daß der Baustein (4) mit seiner Oberseite an der Unterseite einer Subkühlplatte (2) gut wärmeleitend befestigt ist und über einen Spider (7) mit den zugehörigen Lötflecken der Leiterplatte (9) kontaktiert ist, wobei zwischen Bauelement (4) und Leiterplatte (9) Druckstücke (8) angeordnet sind, daß die Subkühlplatte (2) in ihrem unterseitigen Teil konzentrisch angeordnete, mit Kühlflüssigkeit gefüllte Kanäle (3) enthält, und mit ihrer Oberseite gut wärmeleitend an einer Kühlplatte (1) anliegt.

2. Einbausystem nach Anspruch 1, **dadurch gekennzeichnet,** daß die Kühlflüssigkeit einen niedrigen Siedepunkt aufweist.
